# DEMANDE DE BREVET EUROPEEN

(11) **EP 1 130 952 A1**
(43) Date de publication de la demande: **05.09.2001**
(21) Numéro de dépôt: 01400513.6
(22) Date de dépôt: 28.02.2001
(51) Int. Cl.: H05K 7/18, H02B 1/30

(54) **Support modulaire d'assemblage de baies de radiocommunication**

(30) Priorité: 02.03.2000 FR 0002668
(71) Demandeur: Pillosio, Luigi, 94120 Fontenay sous Bois (FR); Pillosio, Guillaume, 94120 Fontenay sous Bois (FR); Pillosio, Raphael, 94120 Fontenay sous Bois (FR)
(72) Inventeur: Pillosio, Luigi, 94120 Fontenay sous Bois (FR); Pillosio, Guillaume, 94120 Fontenay sous Bois (FR); Pillosio, Raphael, 94120 Fontenay sous Bois (FR)

(57) **Abrégé**

L'invention concerne un support modulaire d'assemblage de baies, permettant l'installation de baie de radiocommunication sur des plate formes métalliques existantes

L'invention est composée par un premier cadre périphérique (3) dont les quatre angles (4) comportent des moyeux d'assemblage permettant la solidarisation à un support modulaire semblable. Un second cadre périphérique est prolongé par deux entretoises (6) terminées chacune par une platine (7) comportant des alésages de solidarisation.

La réunion de plusieurs supports modulaires d'assemblage de baies permet la réalisation d'une plate forme pouvant supporter plusieurs baies.

## Description

L'invention a pour objet un dispositif support pour des baies de radiocommunication.
Le territoire national est couvert de sites de réception et d'émission dans le cadre de maillage de radiocommunication. Si ce maillage est relativement simple en dehors des agglomérations, il n'en est pas de même à l'intérieur des villes.
En effet, les émissions sont alors coupées par la présence d'immeubles créant des écrans pour la transmission des signaux. Il est donc nécessaire d'augmenter le nombre des sites de réception et d'émission des ondes radio.
Normalement, une antenne doit être placée aussi haut que possible, c'est pourquoi, les sites privilégiés sont situés sur les terrasses des immeubles de grande hauteur, les châteaux d'eau,...
Les sites comprennent d'une part les antennes panneaux dont les dimensions peuvent varier d'une hauteur de 0.60 à 2.70 mètres et une section de 0.32 x 0.13 mètre d'épaisseur pour la réception et l'émission des signaux, et d'autre part des baies électroniques connectées au réseau filaire, qui gèrent les signaux.
Sur les toitures terrasse, afin de ne pas détériorer le complexe étanche, les baies sont généralement posées sur des plate formes métalliques spécialement créées à cet effet.

Actuellement les baies en terrasses sont posées sur des plate formes surélevées d'environ 40 centimètres au dessus du sol et prenant appui sur les éléments porteurs du gros oeuvre (acrotères, édicules techniques, etc...).
L'ossature métallique des plate formes est composée par des fers du commerce dont l'écartement est fonction des dimensions des baies à supporter. La surface sous la baie est laissée libre pour le passage des câbles.
Les plate formes reçoivent généralement trois baies (une pour chaque antenne)

Les plate formes sont de deux types. Il existe des plate formes de grande dimensions (4.50 mètres x 5.50 mètres), avec cheminement en caillebotis autour des baies, garde corps de protection et emmarchement, et des plate formes réduites au strict minimum, composées de deux fers parallèles, écartés de 0.60 mètres environ, en appui sur les éléments porteurs du gros oeuvre, et supportant les baies électroniques.
Actuellement tous les sites existants sont restructurés pour tenir compte de l'augmentation des abonnés, des avancées techniques en matière de débit des communications et surtout les opérateurs étendent leur réseau aux communications bi-bandes (900 et 1800 Mhz).
Cela se traduit par une multiplication par deux des antennes et des baies, et pose le problème de la gestion de l'espace disponible sur les terrasses, et du réemploi des plate formes existantes, afin de réduire la durée des travaux, et leur coût.

L'invention a pour but de créer un dispositif de support et de fixation des baies, permettant l'adaptation et la pose des nouveaux matériels sur toutes les plate formes existantes, sans réaliser des travaux de serrurerie sur les terrasses d'immeubles.

L'invention concerne d'une façon générale un support modulaire d'assemblage de baies, posé et fixé par boulonnage sur un élément de l'ossature d'une plate forme existante, caractérisée en ce que chaque support modulaire d'assemblage est affecté à une baie.
Plus particulièrement l'invention concerne un dispositif de fixation de baies sur des poutrelles de soutien et se caractérise en ce que chaque baie est fixée sur un support modulaire d'assemblage constitué par un cadre périphérique dont les quatre angles comportent des moyeux d'assemblage permettant la solidarisation à un support modulaire semblable, au moins deux traverses du cadre étant fixées sur les poutrelles de soutien.

Avantageusement chaque traverse du cadre périphérique est constituée par un profilé en forme de C dont les ailes sont au contact du socle de la baie et des poutrelles de soutien. Ainsi, le support modulaire d'assemblage est constitué par un cadre périphérique dont le profilé en forme de C présente une ouverture soit vers l'intérieur du cadre, soit vers l'extérieur.
Les quatre angles du cadre comportent chacun un moyeu dont la hauteur correspond à la hauteur de l'âme du profilé et de ses deux ailes, ce moyeu pouvant être formé par une barre de section sensiblement carrée, pleine ou creuse, une telle barre creuse pouvant être réalisée par soudure de deux sections en équerre. Selon une autre variante de réalisation chaque angle du cadre périphérique est formé par une équerre soudée aux profilés en forme de C.
Selon l'invention chaque moyeu d'angle comporte des alésages orthogonaux deux à deux permettant la solidarisation à au moins un support modulaire semblable et permettant donc un assemblage de plusieurs dispositifs de fixation de baies dans toutes les directions en fonction des plate formes existantes. Plus particulièrement chaque moyeu d'angle comporte deux alésages orthogonaux supérieurs et deux alésages orthogonaux inférieurs. Selon une configuration particulière, chaque support modulaire peut comporter au moins un raidisseur transversal fixé aux deux traverses longitudinales du support modulaire d'assemblage, le cadre périphérique étant réalisé en acier ou bien en alliage léger
Plus particulièrement chaque traverse en forme de C comporte des ailes de longueur inférieure à l'âme, l'aile supérieure comportant des alésages de fixation d'une baie électronique du réseau de téléphonie mobile.
Selon un mode de réalisation adapté à certaines plate formes existantes, le cadre périphérique du support modulaire d'assemblage est prolongé par deux entretoises terminées chacune par une platine comportant des alésages de solidarisation à un support modulaire semblable.

Avantageusement, l'assemblage de deux moyeux permet la reconstitution de la section du profilé et ainsi le cadre conserve une grande rigidité.
Cette caractéristique particulièrement avantageuse permet d'assembler plusieurs supports modulaires et de créer ainsi un support pour de nouvelles baies, adapté à chaque plate forme existante.
Le support modulaire d'assemblage de baies, conçu conformément à l'invention présente un certain nombre d'avantages.
Il permet de conserver et de réutiliser les plate formes existantes qui sont particulièrement récentes (moins de cinq ans d'âge).
De plus selon le mode de réalisation de l'invention, chaque support modulaire de faible poids et d'encombrement réduit, peut être transporté sur la terrasse à bras d'homme, par les escaliers ou l'ascenseur, ce qui exclus l'emploi de moyens de levage lourds au début de chantier.
Ce critère est particulièrement avantageux dans les villes, où les autorisations de grutage sont très réglementées.
Un autre intérêt est la possibilité de faire varier la géométrie des plate formes formées par des supports modulaires d'assemblage en fonction des surfaces disponibles en terrasse. Il est à noter que l'utilisation de pièces modulaires permet pour chaque site, une réduction des frais d'étude, et qui se traduit par des délais d'intervention très courts.

Mais l'invention sera mieux comprise par la description détaillée de certains modes de réalisations donnés à titre de simples exemples et représentés sur les dessins annexés.
La figure 1 est une vue en élévation d'un ensemble baies placées longitudinalement / support modulaire de baie / poutrelles de soutien existantes.
La figure 2 est une vue en coupe de l'ensemble baies placées longitudinalement / support modulaire de baie / poutrelles de soutien existantes, représenté sur la figure 1.
La figure 3 est une vue en élévation d'un ensemble baies placées transversalement / support modulaire de baie / poutrelles de soutien existantes.
La figure 4 est une vue en coupe de l'ensemble baies placées transversalement / support modulaire de baie / poutrelles de soutien existantes, représenté sur la figure 3.
La figure 5 est une vue par dessus de l'ensemble baies placées transversalement */* support modulaire de baie */* poutrelles de soutien existantes, représenté sur la figure 3.
La figure 6 est une coupe d'un support modulaire de baie représenté sur la figure 7.
La figure 7 est une vue par dessus d'un support modulaire de baie dont les moyeux d'angle sont des barres pleines.
La figure 8 est une vue par dessus d'un support modulaire de baie prolongé par deux entretoises.
La figure 9 est une coupe du support modulaire de baie représenté sur la figure 10
La figure 10 est une vue par dessus d'un support modulaire de baie dont les moyeux d'angle sont creux.
La figure 11 est une coupe du support modulaire de baie représenté sur la figure 12.
La figure 12 est une vue par dessus d'un support modulaire de baie dont les moyeux d'angle sont constitués par une cornière. Selon le mode de réalisation représenté aux figures 1 et 2, les baies (1) disposées dos à dos dans le même sens que les poutrelles de soutien (2), sont fixées sur des supports modulaires (3) qui prennent appui sur les poutrelles de soutien (2) existantes à grand écartement.
Selon le mode de réalisation représenté aux figures 3 et 4, les baies (1) disposées dos à dos transversalement aux poutrelles de soutien (2), sont fixées sur des supports modulaires (3) qui prennent appui sur les poutrelles de soutien (2) existantes à faible écartement.

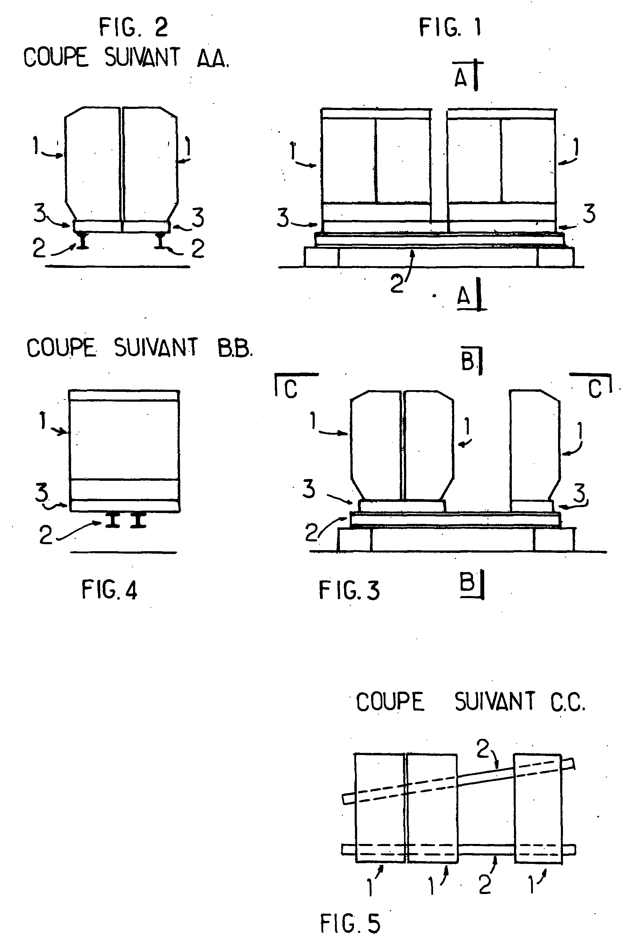

Sur la figure 5, les baies (1) et les supports modulaires (3), prennent appui sur les poutrelles de soutien biaises.

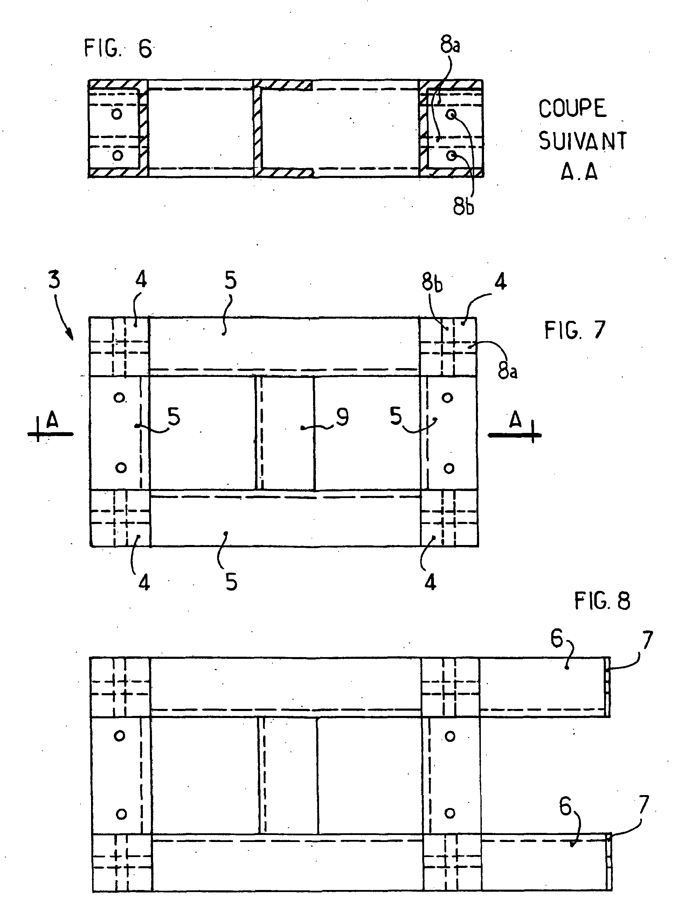

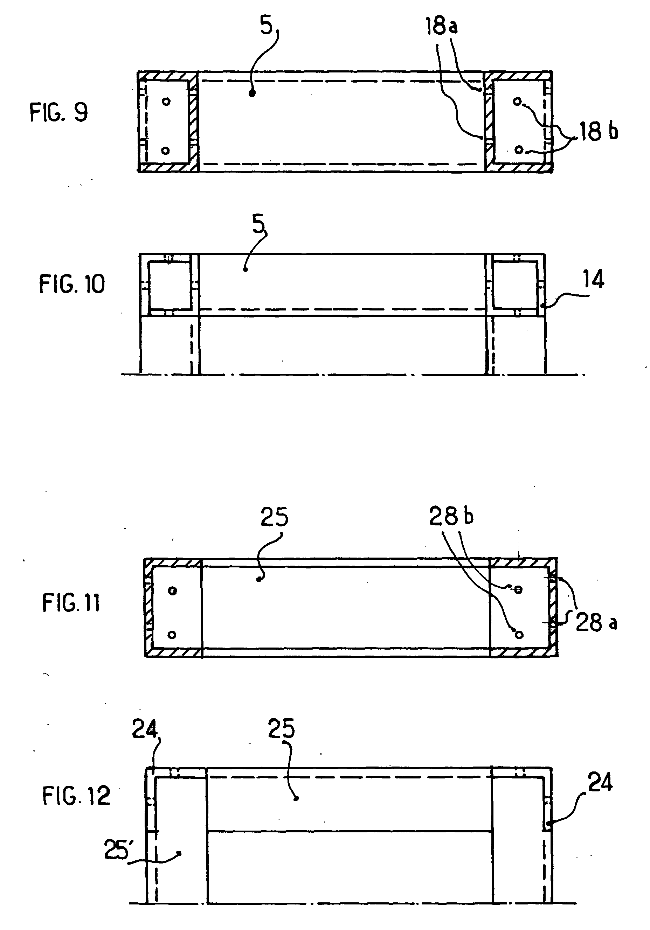

Les figures 1 à 5 montrent la diversité d'utilisation des supports modulaires d'assemblage, quelque soit la géométrie et le type de plate forme existante à équiper.
Selon les deux modes de réalisation représentés sur les figures 6, 7 et 8, chaque baie est fixée sur un cadre périphérique (3) dont les quatre angles (4) sont équipés chacun d'un moyeu d'assemblage, comportant des alésages (8a) (8b) orthogonaux permettant la solidarisation à deux supports modulaires semblables.
Plus particulièrement, chaque traverse (5) du cadre périphérique (3) est constituée par un profilé en forme de C, dont les ailes sont au contact avec la base de la baie (1) et les poutrelles de soutien (2).
Chaque angle (4) du cadre périphérique (3) est formé par une barre de section sensiblement carrée, dont la hauteur correspond à la hauteur de l'âme du profilé (5).
Dans le mode réalisation représenté par la figure 8, le cadre périphérique (3) est prolongé par deux entretoises (6), terminées par une platine (7) comportant des alésages de solidarisation à un support modulaire semblable.
Les cadres (3) comportent un raidisseur transversal (9) fixé aux deux traverses (5).
Sur l'aile supérieure de la traverse (5), des alésages sont prévus pour la fixation de l'embase des baies (1).
Selon le mode de réalisation représenté aux figures 9 et 10, les moyeux d'angle (14) permettant l'assemblage multi directionnel sont creux, et les alésages orthogonaux (18a) et (18b) traversent les deux cornières soudées formant le moyeu lui même soudé aux traverses (5).
Selon le dernier mode de réalisation représenté aux figures 11 et 12, les moyeux d'angle (24) sont réduits à de simples cornières comportant chacune quatre alésages orthogonaux (28a) et (28b), les traverses (25') étant usinées aux deux extrémités afin de loger une aile de la cornière (24) dans le prolongement de l'âme du profilé en C dont l'ouverture est dirigée vers l'intérieur du cadre périphérique

## Revendications

1. Dispositif de fixation de baie (1) sur des poutrelles de soutien (2) , **caractérisé en ce que** chaque baie est fixée sur un support modulaire d'assemblage constitué par un cadre périphérique (3) dont les quatre angles (4,14,24) comportent des moyeux d'assemblage permettant la solidarisation à un support modulaire semblable, au moins deux traverses (5,25) du cadre étant fixées sur les poutrelles de soutien.

2. Dispositif de fixation selon la revendication 1,
**caractérisé en ce que** chaque traverse (5,25,25') du cadre périphérique est constituée par un profilé en forme de C dont les ailes sont au contact du socle de la baie et des poutrelles de soutien.

3. Dispositif de fixation selon l'une des revendication 1 ou 2, **caractérisé en ce que** chaque angle (4) du cadre périphérique (3) est formé par une barre de section sensiblement carrée dont la hauteur correspond à la hauteur de l'âme du profilé et de ses deux ailes.

4. Dispositif de fixation selon la revendication 3,
**caractérisé en ce que** la barre de section sensiblement carrée (14) est creuse.

5. Dispositif de fixation selon l'une des revendications 1 ou 2, **caractérisé en ce que** chaque angle (4) du cadre périphérique (3) est formé par une équerre dont la dont la hauteur correspond à la hauteur de l'âme du profilé (25,25') et de ses deux ailes.

6. Dispositif de fixation selon la revendication 1,
**caractérisé en ce que** le cadre périphérique (3) est prolongé par deux entretoises (6) terminées chacune par une platine (7) comportant des alésages de solidarisation à un support modulaire semblable.

7. Dispositif de fixation selon l'une des revendication 3 à 5,
**caractérisé en ce que** chaque angle (4,14,24) comporte des alésages orthogonaux (8,18,28) de solidarisation à au moins un support modulaire semblable.

8. Dispositif de fixation selon la revendication 7,
**caractérisé en ce que** chaque angle (4,14,24) comporte deux alésages orthogonaux supérieurs (8a,18a,28a) et deux alésages orthogonaux inférieurs (8b, 18b, 28b)

9. Dispositif de fixation selon la revendication 2,
**caractérisé en ce que** chaque traverse (5,25,25') en forme de C comporte des ailes de longueur inférieure à l'âme, l'aile supérieure comportant des alésages de fixation de la baie.

10. Dispositif de fixation selon l'une des revendications précédentes, destiné à la fixation des baies électroniques du réseau de téléphonie mobile.
